# EUROPEAN PATENT SPECIFICATION

(11) **EP 4 513 147 B1**
(45) Date of publication and mention of the grant of the patent: **21.10.2026**
(21) Application number: 22941563.3
(22) Date of filing: 30.12.2022
(51) Int. Cl.: G01D 5/24, H04B 1/40, H01Q 1/52, H01Q 1/24, H01Q 5/328, H01Q 23/00, H03K 17/955, H01Q 5/50

(54) **DETECTION CIRCUIT, DETECTION METHOD, DETECTION DEVICE, MOBILE TERMINAL, AND COMPUTER READABLE STORAGE MEDIUM**
DETEKTIONSSCHALTUNG, DETEKTIONSVERFAHREN, DETEKTIONSVORRICHTUNG, MOBILES ENDGERÄT UND COMPUTERLESBARES SPEICHERMEDIUM
CIRCUIT DE DÉTECTION, PROCÉDÉ DE DÉTECTION, DISPOSITIF DE DÉTECTION, TERMINAL MOBILE ET SUPPORT DE STOCKAGE LISIBLE PAR ORDINATEUR

(30) Priority: 13.05.2022 CN 202210533385
(43) Date of publication of application: 26.02.2025
(73) Proprietor: REALME MOBILE TELECOMMUNICATIONS (SHENZHEN) CO., LTD., Shenzhen, Guangdong 518027 (CN)
(72) Inventor: YANG, Jiangyan, Shenzhen, Guangdong 518066 (CN)
(74) Representative: Novagraaf Technologies
(86) International application number: PCT/CN2022/144043
(87) International publication number: WO 2023/216631

(56) References cited:
- CN-A- 101 958 455
- CN-A- 102 565 861
- CN-A- 109 088 151
- CN-A- 109 474 290
- CN-A- 110 417 434
- CN-A- 111 029 748
- CN-A- 115 014 401
- CN-A- 115 693 138
- CN-B- 109 088 151
- CN-U- 208 173 804
- CN-U- 208 173 804
- US-B2- 10 461 406

## Description

### TECHNICAL FIELD

The present disclosure relates to the field of control technologies, and in particular to a detection circuit, a detection method, a detection device, a mobile terminal, and a computer-readable storage medium.

### BACKGROUND

In related art, a capacitive proximity sensor configured on a mobile terminal is configured to determine whether there is an object approaching based on changes in capacitance. However, during the use of the mobile terminal, an internal circuit may also cause capacitance changes, so that the capacitive proximity sensor incorrectly determines that the object is approaching, reducing the detection accuracy of the capacitive proximity sensor.

CN109088151B provides an antenna system and a mobile terminal, including an antenna device, a SAR sensor, a first decoupling unit, and a second decoupling unit. One end of the first decoupling unit is connected to the SAR sensor, and the other end is connected to a metal frame antenna. The antenna tuning device is connected to the RF signal source, the metal floor, and the second decoupling unit, and the second decoupling unit is connected to the metal frame antenna. The antenna tuning device is used to receive the RF signal emitted by the RF signal source and adjust the resonant frequency of the metal frame antenna. The SAR sensor is used to detect the capacitance value between the metal frame antenna and the metal floor. The first decoupling unit is used to isolate the interference of the RF signals on the operation of the SAR sensor. The second decoupling unit is used to isolate the interference of the SAR sensor signals on the operation of the antenna tuning device.

CN208173 804U provides a mobile terminal antenna circuit, including: an antenna, multiple single pole multi throw switch units, and an inductor. The single pole multi throw switch unit is grounded at one end and connected to an antenna at the other end. The second inductor is connected in parallel on both sides of the single pole multi throw switch unit. The multiple single pole multi throw switch units include at least one inductor.

US10461406B2 provides an antenna assembly that generally combines RF communication circuitry and proximity sensing circuitry. The antenna assembly utilizes a pair of conductive elements (e.g., loop antenna structures) that are parasitically (e.g., capacitively) driven by a directly fed RF feed antenna. The pair of conductive elements are selectively tunable to communicate in a frequency band of RF communication signals by a pair of RF tuning switches. The pair of conductive elements are also utilized as electrodes for proximity sensing by a capacitive proximity sensor module. The proximity sensing module outputs a low frequency signal (as opposed to the high frequency RF signal) to the pair of conductive elements for proximity sensing. The RF tuning switches are isolated from the low frequency signal by a pair of capacitors. The capacitive proximity sensing circuitry is isolated from the RF communication signals by a pair of inductors.

### SUMMARY OF THE DISCLOSURE

In view of this, the embodiments of the present disclosure provide an output detection circuit, a detection method, a detection device, a mobile terminal, and a computer-readable storage medium. It may at least solve the problem that the detection accuracy of the capacitive proximity sensor reduces, because the capacitive proximity sensor in related art incorrectly determines there is an object approaching. The invention is set out in the appended set of claims.

In the embodiments of the present disclosure, the detection circuit includes the first antenna module and the capacitive proximity sensor. The first antenna module includes the multiplexer, the first antenna, and the first inductor. One terminal of the multiplexer is connected to the first antenna and configured for controlling the first antenna to operate in different operating frequency bands. The other terminal of the multiplexer is connected to the ground terminal. The first inductor is connected in parallel with the multiplexer. The capacitive proximity sensor is connected to the first antenna and configured for detecting the capacitance value of the first antenna module. Therefore, the capacitance generated during switching the multiplexer may filtered out through the first inductor, avoiding the false triggering of the capacitive proximity sensor caused by the capacitance generated by the internal circuit of the first antenna module, thereby improving the detection accuracy of the capacitive proximity sensor.

### BRIEF DESCRIPTION OF THE DRAWINGS

FIG. 1 is a schematic view illustrating a connection of a detection circuit in the related art.
FIG. 2 is a schematic view illustrating a detection principle of a capacitive sensor.
FIG. 3 is a schematic view illustrating a connection of a detection circuit in some embodiments of the present disclosure.
FIG. 4 is a schematic flow chart of the detection method in some embodiments of the present disclosure.
FIG. 5 is a structural schematic view of a detection device in some embodiments of the present disclosure.
FIG. 6 is a structural schematic view illustrating a hardware composition of a mobile terminal in some embodiments of the present disclosure.

### DETAILED DESCRIPTION

In the following description, specific details such as specific system structures, technologies, etc., are provided for illustration rather than limitation, so as to facilitate a thorough understanding of the embodiments of the present disclosure. However, those of ordinary skill in the art should know that, the present disclosure may also be implemented in other embodiments without the specific details. In other cases, details of a well-known system, apparatus, and method may be omitted to avoid hindering the description of the present disclosure by unnecessary details.

It should be noted that technical solutions in the embodiments of the present disclosure may be in any combination when there is no conflict.

In addition, in the embodiments of the present disclosure, the terms "first", "second", etc. are configured to distinguish similar objects and not necessarily configured to describe a specific order or sequence.

Before describing the technical solutions of the embodiments of the present disclosure in detail, a brief description of a detection circuit in related art may be given first.

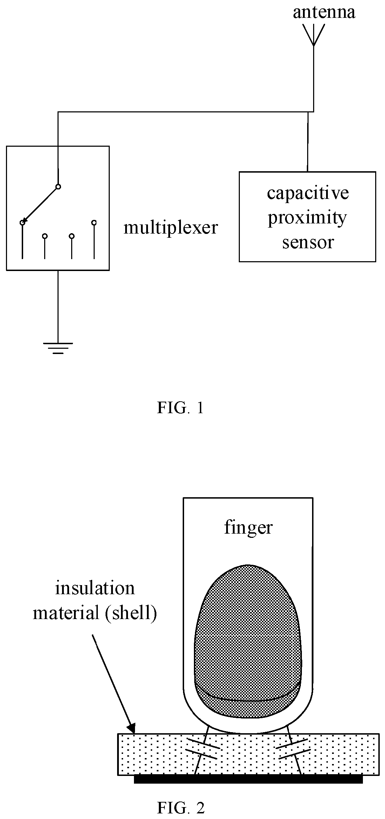

FIG. 1 is a schematic view illustrating a connection of a detection circuit in the related art. As illustrated in FIG. 1, the detection circuit in FIG. 1 includes a multiplexer, an antenna, and a capacitive proximity sensor. One terminal of the multiplexer is connected to the antenna, the other terminal of the multiplexer is connected to a ground terminal. The capacitive proximity sensor is connected to the antenna. When the detection circuit operational, the capacitive proximity sensor may detect a capacitance value of a connection path where the antenna is located or connected. It determines whether an object approaches an area where the antenna is located based on the capacitance value. As illustrated in FIG. 2. FIG. 2 is a schematic view illustrating a detection principle of a capacitive sensor. In the case of a human body approaching the area where the antenna is located (including touching the area where the antenna is located), the human body is equivalent to a capacitor connected to the ground terminal, so that an induced capacitance is formed between the antenna and the ground terminal.

In the detection circuit illustrated in FIG. 1, there are two situations that may trigger changes in the capacitance value of the connection path where the antenna is located. A first situation is that the capacitance is generated due to changes in the external environment. In the first situation, the capacitance is generated because the object approaches the area where the antenna is located. A second situation is that the capacitance is generated by an internal circuit of the antenna. The multiplexer of the detection circuit may control an operating frequency band of a first antenna. For example, a four-way switch provides a RF1 operating frequency band, a RF2 operating frequency band, a RF3 operating frequency band, and a RF4 operating frequency band, respectively. In response to the four-way switch switching between RF1, RF2, RF3, and RF4, the connection path where the antenna is located may generate different sizes of capacitance.

In practical applications, the capacitive proximity sensor cannot distinguish the different situations generating the capacitance. Therefore, in the case where the capacitance is generated by the internal circuit of the antenna, the capacitive proximity sensor may incorrectly determine that the object approaches the area where the antenna is located based on the detected capacitance value, resulting in misjudgment, thereby reducing the detection accuracy of the capacitive proximity sensor.

Based on this, in each embodiment of the present disclosure, the capacitance generated by the internal circuit of the antenna may be prevented from being detected by the capacitive proximity sensor, thereby improving the detection accuracy of the capacitive proximity sensor.

The present disclosure may be explained in detail by combining the accompanying drawings and embodiments.

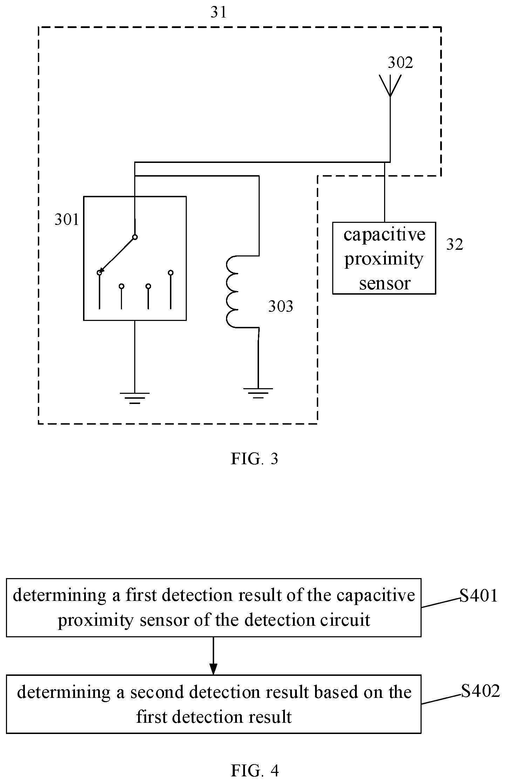

In some embodiments of the present disclosure, a detection circuit is provided. FIG. 3 is a schematic view illustrating a connection of a detection circuit in some embodiments of the present disclosure. As illustrated in FIG. 3, the detection circuit includes a first antenna module 31 and a capacitive proximity sensor 32. The first antenna module 31 includes a multiplexer 301, a first antenna 302, and a first inductor 303.

In the first antenna module 31, one terminal of the multiplexer 301 is connected to the first antenna 302, and the other terminal of the multiplexer 301 is connected to the ground terminal. In some embodiments, the multiplexer 301 may be different types of switches, such as a single pole double throw switch (SP2T), a single pole four throw switch (SP4T), a double pole double throw switch (2P2T), a double pole four throw switch (2P4T), etc. The multiplexer 301 may control the first antenna 302 to operate in different operating frequency bands. In some embodiments, the multiplexer 301 is the SP4T and may provide four different operating frequency bands for the first antenna 302, so as to expand bandwidth; and the multiplexer 301 is also enable the first antenna 302 to operate in the operating frequency band that meets the bandwidth requirements.

The first inductor 303 is connected in parallel with the multiplexer 301. The first inductor 303 has a direct current passing function. In response to the multiplexer 301 continuously switching to change the operating frequency band of the first antenna 302, different sizes of capacitance or different sizes of inductance may be generated during the switching of the multiplexer 301. The capacitance or the inductance may flow into the ground terminal through the first inductor 303, so that the capacitance value of the first antenna module 31 cannot undergo significant changes.

In some embodiments, the inductance with an inductance value greater than or equal to 82 nanohenries and less than or equal to 100 nanohenries is selected as the first inductor 303.

The capacitive proximity sensor 32 is connected to the first antenna 302. In some embodiments, the capacitive proximity sensor 32 is connected to a feeding point of the first antenna 302, so that the first antenna 302 may serve as a metal sensing pad for the capacitive proximity sensor 32. In the case where the object approaches the first antenna module 31, an induced capacitance may be formed between the metal sensing pad (i.e., the first antenna 302) and the object. That is, the capacitive proximity sensor 32 uses the first antenna 302 as a detection path. In response to the object approaching or moving away from the first antenna module 31 (including all directions in the area where the first antenna 302 is located), the capacitive proximity sensor 32 may detect the capacitance value of the first antenna module 31. Due to the direct current passing function of the first inductor 303 (that is the direct current may pass through the first inductor 303), the capacitance generated by the multiplexer 301 may be eliminated. Therefore, the capacitance detected by the capacitive proximity sensor 32 is generated by the external environment (i.e. the object approaching), which improves the detection accuracy of the capacitive proximity sensor 32.

In the above embodiments, the first inductor 303 is connected in parallel with the multiplexer 301, the capacitance generated during the switching of the multiplexer 301 may be eliminated or filtered out through the first inductor 303. Therefore, it may ensure that the capacitance change detected by the capacitive proximity sensor 32 is caused by the object approaching or moving away from the first antenna 302, thereby improving the detection accuracy of the capacitive proximity sensor 32.

In some embodiments, in the case where the mobile terminal is configured with multiple antennas, the first antenna 302 is the antenna that meets a set condition in the mobile terminal, so that the capacitive proximity sensor 32 may reuse the first antenna 302 as the metal sensing pad. In the practical applications, the selection of the first antenna 302 is related to the specific design of the capacitive proximity sensor 32. However, generally, the antenna with the maximum number of supported operating frequency bands, and/or the antenna with the maximum range of supported transmission frequencies, may be used as the first antenna 302. The operating frequency band refers to a transmission frequency band. In the practical applications, the antenna with the maximum range of supported transmission frequencies is used as the first antenna 302, so that the transmission power of the first antenna 302 significantly reduces in response to reducing a radiation value of the mobile terminal.

In the above embodiments, the detection circuit includes the first antenna module 31 and the capacitive proximity sensor 32. The first antenna module 31 includes the multiplexer 301, the first antenna 302, and the first inductor 303. One terminal of the multiplexer 301 is connected to the first antenna 302 and configured for controlling the first antenna 302 to operate in different operating frequency bands. The other terminal of the multiplexer 301 is connected to the ground terminal. The first inductor 303 is connected in parallel with the multiplexer 301. The capacitive proximity sensor 32 is connected to the first antenna 302 and configured for detecting the capacitance value of the first antenna module 31. Therefore, the capacitance generated during switching the multiplexer 301 may filtered out through the first inductor 303, avoiding the false triggering of the capacitive proximity sensor 32 caused by the capacitance generated by the internal circuit of the first antenna module 31, thereby improving the detection accuracy of the capacitive proximity sensor 32.

In the present disclosure, a detection method is further provided. As illustrated in FIG. 4, the detection method includes the following operations.

In an operation S401, the detection method includes determining a first detection result of the capacitive proximity sensor 32 of the detection circuit.

In the embodiments of the present disclosure, the detection circuit is the detection circuit as illustrated in FIG. 3. The capacitive proximity sensor 32 is able to detect the capacitance value of the first antenna module 31. Because the multiplexer 301 is connected in parallel with the first inductor 303, the first inductor 303 may filter out the capacitance generated during the switching of the multiplexer 301. Therefore, the capacitive proximity sensor 32 may not detect the capacitance generated by the multiplexer 301. The capacitive proximity sensor 32 detects the capacitance value of the first antenna module 31 that is generated in response to the object approaching the first antenna module 31. The first detection result is determined by the capacitive proximity sensor 32, and the first detection result reflects the capacitance value of the first antenna module 31.

In an operation S402, the detection method includes determining a second detection result based on the first detection result.

The capacitive proximity sensor 32 detects the capacitance value of the first antenna module 31 that is generated in response to the object approaching the first antenna module 31. Based on the first detection result, the second detection result is determined. The second detection result reflects whether there is the object (including the human body) approaching the first antenna module 31. The object that a distance between the object and the first antenna module 31 is less than or equal to a first set threshold is defined as the object approaching the first antenna module 31. That is, the object is defined as approaching the first antenna module 31 in response to the distance between the object and the first antenna module 31 is less than or equal to the first set threshold. In the practical applications, the detection circuit is usually configured on the mobile terminal, and the capacitive proximity sensor 32 may also be configured to determine whether the human body approaches the first antenna module 31. In the practical applications, the first set threshold is the maximum distance that the object may cause the first antenna module 31 to generate the induced capacitance. In response to the distance between the object and the first antenna module 31 being greater than the maximum distance, it may be considered that the object moves away from the first antenna module 31, and in this case, the object cannot cause the first antenna module 31 to generate the induced capacitance.

In the above embodiments, the first detection result of the capacitive proximity sensor 32 of the detection circuit is determined, and the second detection result is determined based on the first detection result. The first detection result of the capacitive proximity sensor 32 may accurately reflect the capacitance that is generated in response to the object approaching the first antenna module 31, thereby improving the detection accuracy of the capacitive proximity sensor 32.

In some embodiments, the correspondence between the first detection result and the second detection result is described. In the practical applications, in the case where the object approaches or even touches the first antenna module 31, the object acts as the capacitor connected to the ground terminal. The first antenna module 31 acts as the metal sensing pad of the capacitive proximity sensor 32, the induced capacitance may be formed between the first antenna module 31 and the ground terminal. The capacitance of the induced capacitance is within a first set range (usually several pF to tens of pF). By determining whether the first detection result matches the first set range, the corresponding second detection result may be obtained.

The first detection result indicates that the capacitance value of the first antenna module 31 is within the first set range, and the capacitive proximity sensor 32 detects the capacitance generated by the object approaching the first antenna module 31. It may be determined that the second detection result indicates there is the object whose distance from the first antenna module 31 is less than or equal to the first set threshold.

The first detection result indicates that the capacitance value of the first antenna module 31 is not within the first set range. This is, the capacitive proximity sensor 31 detects that the capacitance value of the first antenna module 31 is less than the minimum capacitance value within the first set range, or the capacitive proximity sensor 31 detects that the capacitance value of the first antenna module 31 is greater than the maximum capacitance value within the first set range. It may be considered that the capacitive proximity sensor 31 detects that there is no capacitance in the first antenna module 31, or the capacitance value detected by the capacitive proximity sensor 31 is not generated by the object approaching the first antenna module 31. It may be determined that the second detection result indicates there is no object whose distance from the first antenna module 31 is less than or equal to the first set threshold.

In some embodiments, the mobile terminal is able to generate electromagnetic radiation, and the electromagnetic radiation refers to the phenomenon that energy is emitted into a space in the form of an electromagnetic wave. The electromagnetic radiation greater than 2 milligauss may cause illness in the human body. In the practical applications, a specific absorption rate (SAR) is usually configured to measure the magnitude of the electromagnetic radiation. In order to reduce the impact of the electromagnetic radiation from the mobile terminal, the SAR of the mobile terminal may be adjusted by using the capacitive proximity sensor 32. In some embodiments, the SAR of the mobile terminal is adjusted by adjusting the transmission power of the first antenna 302, and the transmission power of the first antenna 302 is determined based on the second detection result.

In some embodiments, in the case where the second detection result indicates there is the object whose distance from the first antenna module 31 is less than or equal to the first set threshold, it may correspond to a user using the mobile terminal for communication, so that the user approaches the mobile terminal, or a distance between the user and the mobile terminal is too close. In this case, it is necessary to reduce the SAR of the mobile terminal, so as to avoid harm to the user caused by the electromagnetic radiation from the mobile terminal. In some embodiments, the transmission power of the first antenna 302 is adjusted from a first power level to a second power level. That is, the transmission power of the first antenna 302 reduces, thereby reducing the SAR of the mobile terminal.

In the practical applications, the second detection result changes, for example, the change from the presence of the object whose distance from the first antenna module 31 is less than or equal to the first set threshold to the absence of such an object. For example, the user may place the mobile terminal at a location away from themselves after ending a call, thereby transitioning from being close to the mobile terminal to being away from the mobile terminal, and as a result, the corresponding second detection result changes. In this case, the transmission power of the first antenna 302 may be adjusted from the second power level to the first power level, increasing the transmission power of the first antenna 302.

In the above embodiments, the second detection result is detecting whether there is the capacitance in the first antenna module 31 based on the capacitive proximity sensor 32, and the capacitance is generated by the object approaching the first antenna module 31. Therefore, it may accurately identify the situation that the user approaches the mobile terminal, thereby accurately adjusting the transmission power of the first antenna 302 and reducing the SAR of the mobile terminal. Therefore, it may avoid changes in the transmission power of the first antenna 302 due to incorrect triggering of the capacitive proximity sensor 32.

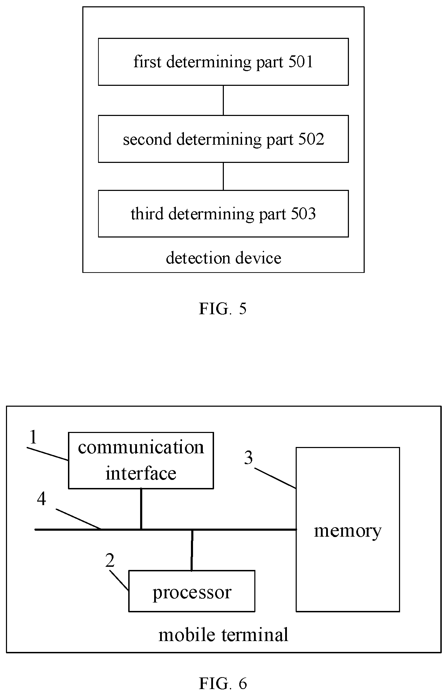

In order to implement the detection method in the embodiments of the present disclosure, in some embodiments, a detection device is further provided. As illustrated in FIG. 5, the detection device includes a first determining part 501, a second determining part 502, and a third determining part 503.

The first determining part 501 is configured to determine the first detection result of the capacitive proximity sensor 32 of the detection circuit. The detection circuit includes any one of the detection circuits described in the above embodiments.

The second determining part 502 is configured to determine the second detection result based on the first detection result. The second detection result indicates whether there is the object whose distance from the first antenna module 31 of the detection circuit is less than or equal to the first set threshold.

In some embodiments, the detection device includes the first determining part 501 and the second determining part 502.

In some embodiments, the detection device further includes the third determining part 503.

The third determining part 503 is configured to determine the transmission power of the first antenna 302 based on the second detection result.

In some embodiments, the third determining part 503 is configured not only for determining the transmission power of the first antenna 302 based on the second detection result, but also for:
adjusting the transmission power of the first antenna 302 from the first power level to the second power level in the case where the second detection result indicates that the distance between the first antenna module 31 and the object is less than or equal to the first set threshold, wherein the transmission power corresponding to the first power level is greater than the transmission power corresponding to the second power level.

In some embodiments, the second determining part 502 is configured not only for determining the second detection result based on the first detection result, but also for:
determining that the second detection result indicates there is the object whose distance from the first antenna module 31 of the detection circuit is less than or equal to the first set threshold in the case where the first detection result indicates that the capacitance value of the first antenna module 31 is within the first set range; and
determining that the second detection result indicates there is no the object whose distance from the first antenna module 31 of the detection circuit is less than or equal to the first set threshold in the case where the first detection result indicates that the capacitance value of the first antenna module 31 is not within the first set range.

In the practical applications, the first determining part 501, the second determining part 502, and the third determining part 503 may be implemented by a processor of the detection device. The processor needs to run programs stored in a memory, so as to implement the functions of the various program modules mentioned above.

It should be noted that the detection device in the above embodiment of FIG. 5 only illustrates the division of each program module during detection. In the practical applications, the above processing may be assigned to different program modules according to need. That is, the internal structure of the detection device may be divided into different program modules to complete all or part of the processing described above. In addition, the detection device and detection method in the above embodiments belong to the same concept, and the specific implementation process of the detection device is detailed in the method embodiments, which may not be repeated here.

Based on the hardware implementation of the above program modules, and in order to implement the detection method in the embodiments of the present disclosure, the embodiments of the present disclosure further provide an electronic device. FIG. 6 is a structural schematic view illustrating a hardware composition of the electronic device in some embodiments of the present disclosure. As illustrated in FIG. 6, the electronic device includes a communication interface 1 and a processor 2.

The communication interface 1 is able to exchange information with other devices, such as a network device.

The processor 2 is connected to the communication interface 1, so as to exchange information with other devices. The processor 2 is configured to implement one or more detection methods in above embodiments in response to running the computer programs. And the computer program is stored on memory 3.

In the practical applications, the various components of the electronic device are coupled together through a bus system 4. The bus system 4 is configured to achieve connection and communication between these components. The bus system 4 includes not only a data bus, but also a power bus, a control bus, and a status signal bus. However, for the sake of clarity, various buses are labeled as the bus system 4 in FIG. 6.

The memory 3 in the embodiments of the present disclosure is configured to store various types of data to support the operation of the electronic device. The data includes any computer program configured for operating on the electronic device.

The memory 3 may be a volatile memory or a non-volatile memory, or the memory 3 may include the volatile memory and the non-volatile memory. The non-volatile memory may be a Read-Only Memory (ROM), a Programmable Read-Only Memory (PROM), an Erasable Programmable Read-Only Memory (EPROM), an Electrically Erasable Programmable Read-Only Memory (EEPROM), a Ferromagnetic Random Access Memory (FRAM), a Flash Memory, a magnetic surface memory, a compact disk, or a Compact Disc Read-Only Memory (CD-ROM). The magnetic surface memory may be a disk memory or a magnetic tape memory. The volatile memory may be a Random Access Memory (RAM) which serves as an external cache. By way of exemplary but not restrictive illustrations, many forms of RAMs are available, such as a Static Random Access Memory (SRAM), a Synchronous Static Random Access Memory (SSRAM), a Dynamic Random Access Memory (DRAM), a Synchronous Dynamic Random Access Memory (SDRAM), a Double Data Rate Synchronous Dynamic Random Access Memory (DDRSDRAM), an Enhanced Synchronous Dynamic Random Access Memory (ESDRAM), a SyncLink Dynamic Random Access Memory (SLDRAM), and a Direct Rambus Random Access Memory (DRRAM). The memory 3 described in the embodiments is intended to include, but is not limited to, these and any other suitable types of memories.

The method disclosed in the above embodiments of the present disclosure may be applied to the processor 2 or implemented by the processor 2. The processor 2 may be an integrated circuit chip with a signal processing capability. In the implementation process, each operation of the above method may be completed through an integrated logic circuit of the hardware or instructions in software form in the processor 2. The processor 2 may be a general-purpose processor, a Digital Signal Processor (DSP), or other programmable logic devices, a discrete gate or transistor logic device, or a discrete hardware component, etc. The processor 2 may implement or execute the disclosed methods, operations, and logic diagrams in the embodiments of the present disclosure. The general-purpose processor may be a microprocessor or any conventional processor, etc. The operations of the method disclosed in the embodiments of the present disclosure may be implemented by a hardware decoding processor, or a combination of the hardware module and the software module of the decoding processor. The software module may be disposed in a computer-readable storage medium, and the computer-readable storage medium is disposed in the memory 3. The processor 2 reads the program in the memory 3. The operations of the method are implemented by the processor 2 combined with the hardware.

The processes corresponding to the various methods in the embodiments of the present disclosure are implemented in response to the processor 2 executing the program. For the sake of simplicity, these processes may not be repeated here.

In some embodiments of the present disclosure, a computer-readable storage medium is further provided, such as the memory 3 that stores the computer program. The computer program may be executed by the processor 2, so as to implement the operations in the method of any one of the above embodiments. The computer readable storage media may be the memory, such as the FRAM, the ROM, the PROM, the EPROM, the EEPROM, the Flash Memory, the magnetic surface storage, the Compact Disc, or the CD-ROM storage, etc.

In the several embodiments provided in the present disclosure, it should be understood that the disclosed device, terminal, and method may be implemented in other manners. The described device embodiments are merely exemplary. For example, the unit division is merely a logical function division and may be other divisions during actual implementation. For example, a plurality of units or components may be merged or integrated into another system, or some features may be ignored or not performed. In addition, the coupling, direct coupling, or communication connection between the various components displayed or discussed may be indirect coupling or communication connection through some interfaces, devices, or units, which may be electrical, mechanical, or other forms.

The units described as separation components may be or may not be physically separated. The component used as display unit may be or may not be a physical unit. That is, the units may be located in the same place, or may be distributed to many network units. Some or all of the units may be selected according to actual requirements, so as to implement the solutions of the embodiments.

In addition, functional units in the embodiments of the present disclosure may be all integrated in a processing unit, each unit is separately used as one unit, or two or more units are integrated in one unit. The integrated unit may be implemented in a form of hardware, or may be implemented in form of a combination of a hardware functional unit and a software functional unit.

Those of ordinary skill in the art may understand that all or part of the operations to implement the above method embodiments may be completed through the hardware related to program instructions. The aforementioned program may be stored in a computer-readable storage medium. During executing the program, the operations of the above method embodiments are implemented; The aforementioned computer-readable storage media may include various media that may store program code, such as a mobile storage device, the ROM, the RAM, a disk, or the compact disc.

Alternatively, when the integrated units mentioned above are implemented in the form of the software functional module, and sold or used as an independent product, the integrated units may also be stored in the computer-readable storage medium. Based on such an understanding, the technical solution of the embodiments of the present disclosure essentially or partially contribute to the related art may be reflected in the form of a software product. The software product is stored in the computer-readable storage medium and includes several instructions for enabling an electronic device (which may be a personal computer, a server, or a network device, etc.) to perform all or a part of the methods described in various embodiments of the present disclosure. The aforementioned computer-readable storage media may include various media that may store program code, such as the mobile storage device, the ROM, the RAM, the disk, or the compact disc.

The descriptions are only specific implementations of the present disclosure, but are not intended to limit the protection scope of the present disclosure. Any variation or replacement readily figured out by persons skilled in the art within the technical scope disclosed in the present disclosure should fall within the protection scope of the present disclosure. Therefore, the protection scope of the present disclosure should be subject to the protection scope of the claims.

## Claims

1. A detection circuit, comprising:
a first antenna module (31), comprising a first antenna (302), a first inductor (303), and a multiplexer (301); wherein one terminal of the multiplexer (301) is connected to the first antenna (302) and configured to control the first antenna (302) to operate in different operating frequency bands, and the other terminal of the multiplexer (301) is connected to a ground terminal; and the first inductor (303) is connected in parallel with the multiplexer (301); and
a capacitive proximity sensor (32), connected to the first antenna (302) and configured for detecting a capacitance value of the first antenna module (31);
**characterized in that**, a first detection result of the capacitive proximity sensor (32) is configured to indicate the capacitance value that is generated in response to an object approaching the first antenna module (31), a second detection result of the capacitive proximity sensor (32) is configured to indicate whether there is the object whose distance from the first antenna module (31) of the detection circuit is less than or equal to a first set threshold, and the second detection result is determined in response to the first detection result matching a first set range.

2. The detection circuit according to claim 1, wherein in a plurality of antennas configured on a mobile terminal, the first antenna (302) is one of the antennas that meets a set condition; and the set condition comprises at least one of the following conditions:
the maximum number of supported operating frequency bands; and
the maximum range of supported transmission frequencies.

3. The detection circuit according to claim 1, wherein an inductance value of the first inductor (303) is greater than or equal to 82 nanohenries and less than or equal to 100 nanohenries.

4. The detection circuit according to claim 1, wherein the capacitive proximity sensor (32) is connected to a feeding point of the first antenna (302), so that in the case where the object approaches the first antenna module (31), an induced capacitance is formed between the first antenna (302) and the object.

5. The detection circuit according to claim 1, wherein the multiplexer (301) is connected in parallel with the first inductor (303), so that the first inductor (303) is configured to filter out capacitance generated during switching of the multiplexer (301).

6. A detection method, comprising:
determining (S401) a first detection result of a capacitive proximity sensor (32) of a detection circuit, wherein the detection circuit is the detection circuit according to any one of claims 1 to 5; and
determining (S402) a second detection result based on the first detection result and the first set range, wherein the second detection result indicates whether there is an object whose distance from the first antenna module (31) of the detection circuit is less than or equal to a first set threshold.

7. The detection method according to claim 6, wherein the detection method further comprises:
determining transmission power of the first antenna (302) based on the second detection result.

8. The detection method according to claim 7, wherein the determining transmission power of the first antenna (302) based on the second detection result, comprises:
adjusting the transmission power of the first antenna (302) from a first power level to a second power level in the case where the second detection result indicates that a distance between the first antenna module (31) and an object to be detected is less than or equal to the first set threshold;
wherein the transmission power corresponding to the first power level is greater than the transmission power corresponding to the second power level.

9. The detection method according to claim 6, wherein the determining (S402) a second detection result based on the first detection result, comprises:
determining that the second detection result indicates there is the object whose distance from the first antenna module (31) of the detection circuit is less than or equal to the first set threshold in the case where the first detection result indicates that a capacitance value of the first antenna module (31) is within the first set range; and
determining that the second detection result indicates there is no object whose distance from the first antenna module (31) of the detection circuit is less than or equal to the first set threshold in the case where the first detection result indicates that the capacitance value of the first antenna module (31) is not within the first set range.

10. A detection device, **characterized by** comprising:
a first determining part (501), configured to determine a first detection result of a capacitive proximity sensor (32) of a detection circuit, wherein the detection circuit is the detection circuit according to any one of claims 1 to 5; and
a second determining part (502), configured to determine a second detection result based on the first detection result and the first set range; wherein the second detection result indicates whether there is an object whose distance from the first antenna module (31) of the detection circuit is less than or equal to a first set threshold.

11. The detection device according to claim 10, wherein the detection device further comprises:
a third determining part (503), configured to determine transmission power of the first antenna (302) based on the second detection result.

12. The detection device according to claim 11, wherein the third determining part (503) is further configured for:
adjusting the transmission power of the first antenna (302) from a first power level to a second power level in the case where the second detection result indicates that a distance between the first antenna module (31) and the object is less than or equal to the first set threshold;
wherein the transmission power corresponding to the first power level is greater than the transmission power corresponding to the second power level.

13. The detection device according to claim 10, wherein the second determining part (502) is further configured for:
determining that the second detection result indicates there is the object whose distance from the first antenna module (31) of the detection circuit is less than or equal to the first set threshold in the case where the first detection result indicates that a capacitance value of the first antenna module (31) is within the first set range; and
determining that the second detection result indicates there is no object whose distance from the first antenna module (31) of the detection circuit is less than or equal to the first set threshold in the case where the first detection result indicates that the capacitance value of the first antenna module (31) is not within the first set range.

14. A mobile terminal, **characterized by** comprising:
a processor (2); and
a memory (3), configured for storing a computer program that is able to run on the processor (2),
wherein the processor (2) is configured to implement operations of the detection method according to any one of claims 6 to 9 in response to running the computer program.

15. A computer-readable storage medium storing a computer program, **characterized in that** operations of the detection method according to any one of claims 6 to 9 are implemented in response to the computer program being executed by a processor (2).

## Patentansprüche

1. Detektionsschaltung, umfassend:
ein erstes Antennenmodul (31), das eine erste Antenne (302), eine erste Induktivität (303) und einen Multiplexer (301) umfasst; wobei ein Anschluss des Multiplexers (301) mit der ersten Antenne (302) verbunden ist und ausgelegt ist, die erste Antenne (302) so zu steuern, dass sie in unterschiedlichen Betriebsfrequenzbändern arbeitet, und der andere Anschluss des Multiplexers (301) mit einem Masseanschluss verbunden ist; und die erste Induktivität (303) mit dem Multiplexer (301) parallel geschaltet ist; und
einen kapazitiven Näherungssensor (32), der mit der ersten Antenne (302) verbunden und zum Detektieren eines Kapazitätswerts des ersten Antennenmoduls (31) ausgelegt ist;
**dadurch gekennzeichnet, dass**
ein erstes Detektionsergebnis des kapazitiven Näherungssensors (32) ausgelegt ist zum Angeben des Kapazitätswerts, der als Reaktion darauf erzeugt wird,
dass sich ein Objekt dem ersten Antennenmodul (31) nähert, ein zweites Detektionsergebnis des kapazitiven Näherungssensors (32) ausgelegt ist anzugeben, ob das Objekt vorhanden ist, dessen Abstand vom ersten Antennenmodul (31) der Detektionsschaltung kleiner oder gleich einer ersten eingestellten Schwelle ist, und das zweite Detektionsergebnis als Reaktion darauf bestimmt wird, dass das erste Detektionsergebnis mit einem ersten eingestellten Bereich übereinstimmt.

2. Detektionsschaltung nach Anspruch 1, wobei in mehreren Antennen, die an einem mobilen Endgerät konfiguriert sind, die erste Antenne (302) eine der Antennen ist, die eine eingestellte Bedingung erfüllt; und die eingestellte Bedingung mindestens eine der folgenden Bedingungen umfasst:
die maximale Anzahl unterstützter Betriebsfrequenzbänder; und
den maximalen Bereich unterstützter Sendefrequenzen.

3. Detektionsschaltung nach Anspruch 1, wobei ein Induktivitätswert der ersten Induktivität (303) größer als oder gleich 82 Nanohenrys und kleiner als oder gleich 100 Nanohenrys ist.

4. Detektionsschaltung nach Anspruch 1, wobei der kapazitive Näherungssensor (32) mit einem Speisepunkt der ersten Antenne (302) verbunden ist, sodass im Fall, dass sich das Objekt dem ersten Antennenmodul (31) nähert, eine induzierte Kapazität zwischen der ersten Antenne (302) und dem Objekt gebildet wird.

5. Detektionsschaltung nach Anspruch 1, wobei der Multiplexer (301) mit der ersten Induktivität (303) parallel geschaltet ist, so dass die erste Induktivität (303) ausgelegt ist zum Ausfiltern von während des Schaltens des Multiplexers (301) erzeugter Kapazität.

6. Detektionsverfahren, umfassend:
Bestimmen (S401) eines ersten Detektionsergebnisses eines kapazitiven Näherungssensors (32) einer Detektionsschaltung, wobei die Detektionsschaltung die Detektionsschaltung nach einem der Ansprüche 1 bis 5 ist; und
Bestimmen (S402) eines zweiten Detektionsergebnisses basierend auf dem ersten Detektionsergebnis und dem ersten eingestellten Bereich, wobei das zweite Detektionsergebnis angibt, ob es ein Objekt gibt, dessen Abstand vom ersten Antennenmodul (31) der Detektionsschaltung kleiner oder gleich einer ersten eingestellten Schwelle ist.

7. Detektionsverfahren nach Anspruch 6, wobei das Detektionsverfahren ferner umfasst:
Bestimmen der Sendeleistung der ersten Antenne (302) basierend auf dem zweiten Detektionsergebnis.

8. Detektionsverfahren nach Anspruch 7, wobei das Bestimmen der Sendeleistung der ersten Antenne (302) basierend auf dem zweiten Detektionsergebnis umfasst:
Anpassen der Sendeleistung der ersten Antenne (302) von einem ersten Leistungspegel auf einen zweiten Leistungspegel im Fall, dass das zweite Detektionsergebnis angibt, dass ein Abstand zwischen dem ersten Antennenmodul (31) und einem zu detektierenden Objekt kleiner oder gleich der ersten eingestellten Schwelle ist;
wobei die Sendeleistung, die dem ersten Leistungspegel entspricht, größer als die Sendeleistung ist, die dem zweiten Leistungspegel entspricht.

9. Detektionsverfahren nach Anspruch 6, wobei das Bestimmen (S402) eines zweiten Detektionsergebnisses basierend auf dem ersten Detektionsergebnis umfasst:
Bestimmen, dass das zweite Detektionsergebnis angibt, dass es das Objekt gibt, dessen Abstand vom ersten Antennenmodul (31) der Detektionsschaltung kleiner oder gleich der ersten eingestellten Schwelle ist, im Fall, dass das erste Detektionsergebnis angibt, dass ein Kapazitätswert des ersten Antennenmoduls (31) innerhalb des ersten eingestellten Bereichs liegt; und
Bestimmen, dass das zweite Detektionsergebnis angibt, dass es kein Objekt gibt, dessen Abstand vom ersten Antennenmodul (31) der Detektionsschaltung kleiner oder gleich der ersten eingestellten Schwelle ist, im Fall, dass das erste Detektionsergebnis angibt, dass der Kapazitätswert des ersten Antennenmoduls (31) nicht innerhalb des ersten eingestellten Bereichs liegt.

10. Detektionsvorrichtung, **dadurch gekennzeichnet, dass** sie umfasst:
einen ersten Bestimmungsteil (501), der ausgelegt ist zum Bestimmen eines ersten Detektionsergebnisses eines kapazitiven Näherungssensors (32) einer Detektionsschaltung, wobei die Detektionsschaltung die Detektionsschaltung nach einem der Ansprüche 1 bis 5 ist; und
einen zweiten Bestimmungsteil (502), der ausgelegt ist zum Bestimmen eines zweiten Detektionsergebnisses basierend auf dem ersten Detektionsergebnis und dem ersten eingestellten Bereich, wobei das zweite Detektionsergebnis angibt, ob es ein Objekt gibt, dessen Abstand vom ersten Antennenmodul (31) der Detektionsschaltung kleiner oder gleich einer ersten eingestellten Schwelle ist.

11. Detektionsvorrichtung nach Anspruch 10, wobei die Detektionsvorrichtung ferner umfasst:
einen dritten Bestimmungsteil (503), der ausgelegt ist zum Bestimmen der Sendeleistung der ersten Antenne (302) basierend auf dem zweiten Detektionsergebnis.

12. Detektionsvorrichtung nach Anspruch 11, wobei der dritte Bestimmungsteil (503) ferner ausgelegt ist zum:
Anpassen der Sendeleistung der ersten Antenne (302) von einem ersten Leistungspegel auf einen zweiten Leistungspegel im Fall, dass das zweite Detektionsergebnis angibt, dass ein Abstand zwischen dem ersten Antennenmodul (31) und dem Objekt kleiner oder gleich der ersten eingestellten Schwelle ist;
wobei die Sendeleistung, die dem ersten Leistungspegel entspricht, größer als die Sendeleistung ist, die dem zweiten Leistungspegel entspricht.

13. Detektionsvorrichtung nach Anspruch 10, wobei der zweite Bestimmungsteil (502) ferner ausgelegt ist zum:
Bestimmen, dass das zweite Detektionsergebnis angibt, dass es das Objekt gibt, dessen Abstand vom ersten Antennenmodul (31) der Detektionsschaltung kleiner oder gleich der ersten eingestellten Schwelle ist, im Fall, dass das erste Detektionsergebnis angibt, dass ein Kapazitätswert des ersten Antennenmoduls (31) innerhalb des ersten eingestellten Bereichs liegt; und
Bestimmen, dass das zweite Detektionsergebnis angibt, dass es kein Objekt gibt, dessen Abstand vom ersten Antennenmodul (31) der Detektionsschaltung kleiner oder gleich der ersten eingestellten Schwelle ist, im Fall, dass das erste Detektionsergebnis angibt, dass der Kapazitätswert des ersten Antennenmoduls (31) nicht innerhalb des ersten eingestellten Bereichs liegt.

14. Mobiles Endgerät, **dadurch gekennzeichnet, dass** es umfasst:
einen Prozessor (2); und
einen Speicher (3), der ausgelegt ist zum Speichern eines Computerprogramms, das auf dem Prozessor (2) ausgeführt werden kann,
wobei der Prozessor (2) ausgelegt ist zum Implementieren von Operationen des Detektionsverfahrens nach einem der Ansprüche 6 bis 9 als Reaktion auf das Ausführen des Computerprogramms.

15. Computerlesbares Speichermedium, das ein Computerprogramm speichert, **dadurch gekennzeichnet, dass** Operationen des Detektionsverfahrens nach einem der Ansprüche 6 bis 9 als Reaktion darauf implementiert werden, dass das Computerprogramm durch einen Prozessor (2) ausgeführt wird.

## Revendications

1. Circuit de détection, comprenant :
un premier module d'antenne (31), comprenant une première antenne (302), une première inductance (303) et un multiplexeur (301) ; une borne du multiplexeur (301) étant connectée à la première antenne (302) et configurée pour commander la première antenne (302) afin qu'elle fonctionne dans différentes bandes de fréquences de fonctionnement, et l'autre borne du multiplexeur (301) étant connectée à une borne de masse ; et la première inductance (303) étant connectée en parallèle avec le multiplexeur (301) ; et
un capteur de proximité capacitif (32), connecté à la première antenne (302) et configuré pour détecter une valeur de capacité du premier module d'antenne (31) ;
**caractérisé en ce que** :
un premier résultat de détection du capteur de proximité capacitif (32) est configuré pour indiquer la valeur de capacité générée en réponse au fait qu'un objet s'approche du premier module d'antenne (31), un deuxième résultat de détection du capteur de proximité capacitif (32) est configuré pour indiquer si l'objet est présent à une distance du premier module d'antenne (31) du circuit de détection qui est inférieure ou égale à un premier seuil défini, et le deuxième résultat de détection est déterminé en réponse au fait que le premier résultat de détection s'inscrit dans une première plage définie.

2. Circuit de détection selon la revendication 1, dans lequel, dans une pluralité d'antennes configurées sur un terminal mobile, la première antenne (302) est l'une des antennes satisfaisant à une condition définie ; et la condition définie comprend au moins l'une des conditions suivantes :
le nombre maximal de bandes de fréquences de fonctionnement prises en charge ; et
la plage maximale des fréquences d'émission prises en charge.

3. Circuit de détection selon la revendication 1, dans lequel une valeur d'inductance de la première inductance (303) est supérieure ou égale à 82 nanohenrys et inférieure ou égale à 100 nanohenrys.

4. Circuit de détection selon la revendication 1, dans lequel le capteur de proximité capacitif (32) est connecté à un point d'alimentation de la première antenne (302), de sorte que, dans le cas où l'objet s'approche du premier module d'antenne (31), une capacité induite est formée entre la première antenne (302) et l'objet.

5. Circuit de détection selon la revendication 1, dans lequel le multiplexeur (301) est connecté en parallèle avec la première inductance (303), de sorte que la première inductance (303) est configurée pour éliminer par filtrage la capacité générée pendant la commutation du multiplexeur (301).

6. Procédé de détection, comprenant :
la détermination (S401) d'un premier résultat de détection d'un capteur de proximité capacitif (32) d'un circuit de détection, le circuit de détection étant le circuit de détection selon l'une quelconque des revendications 1 à 5 ; et
la détermination (S402) d'un deuxième résultat de détection sur la base du premier résultat de détection et de la première plage définie, le deuxième résultat de détection indiquant si un objet est présent à une distance du premier module d'antenne (31) du circuit de détection qui est inférieure ou égale à un premier seuil défini.

7. Procédé de détection selon la revendication 6, le procédé de détection comprenant en outre :
la détermination d'une puissance d'émission de la première antenne (302) sur la base du deuxième résultat de détection.

8. Procédé de détection selon la revendication 7, dans lequel la détermination d'une puissance d'émission de la première antenne (302) sur la base du deuxième résultat de détection comprend :
l'ajustement de la puissance d'émission de la première antenne (302) d'un premier niveau de puissance à un deuxième niveau de puissance dans le cas où le deuxième résultat de détection indique qu'une distance entre le premier module d'antenne (31) et un objet à détecter est inférieure ou égale au premier seuil défini ;
dans lequel la puissance d'émission correspondant au premier niveau de puissance est supérieure à la puissance d'émission correspondant au deuxième niveau de puissance.

9. Procédé de détection selon la revendication 6, dans lequel la détermination (S402) d'un deuxième résultat de détection sur la base du premier résultat de détection comprend :
la détermination que le deuxième résultat de détection indique que l'objet est présent à une distance du premier module d'antenne (31) du circuit de détection qui est inférieure ou égale au premier seuil défini dans le cas où le premier résultat de détection indique qu'une valeur de capacité du premier module d'antenne (31) se situe dans la première plage définie ; et
la détermination que le deuxième résultat de détection indique qu'aucun objet n'est présent à une distance du premier module d'antenne (31) du circuit de détection qui est inférieure ou égale au premier seuil défini dans le cas où le premier résultat de détection indique que la valeur de capacité du premier module d'antenne (31) ne se situe pas dans la première plage définie.

10. Dispositif de détection, **caractérisé en ce qu'**il comprend :
une première unité de détermination (501), configurée pour déterminer un premier résultat de détection d'un capteur de proximité capacitif (32) d'un circuit de détection, le circuit de détection étant le circuit de détection selon l'une quelconque des revendications 1 à 5 ; et
une deuxième unité de détermination (502), configurée pour déterminer un deuxième résultat de détection sur la base du premier résultat de détection et de la première plage définie ; le deuxième résultat de détection indiquant si un objet est présent à une distance du premier module d'antenne (31) du circuit de détection qui est inférieure ou égale à un premier seuil défini.

11. Dispositif de détection selon la revendication 10, le dispositif de détection comprenant en outre :
une troisième unité de détermination (503), configurée pour déterminer une puissance d'émission de la première antenne (302) sur la base du deuxième résultat de détection.

12. Dispositif de détection selon la revendication 11, dans lequel la troisième unité de détermination (503) est en outre configurée pour :
ajuster la puissance d'émission de la première antenne (302) d'un premier niveau de puissance à un deuxième niveau de puissance dans le cas où le deuxième résultat de détection indique qu'une distance entre le premier module d'antenne (31) et l'objet est inférieure ou égale au premier seuil défini ;
dans lequel la puissance d'émission correspondant au premier niveau de puissance est supérieure à la puissance d'émission correspondant au deuxième niveau de puissance.

13. Dispositif de détection selon la revendication 10, dans lequel la deuxième unité de détermination (502) est en outre configurée pour :
déterminer que le deuxième résultat de détection indique que l'objet est présent à une distance du premier module d'antenne (31) du circuit de détection qui est inférieure ou égale au premier seuil défini dans le cas où le premier résultat de détection indique qu'une valeur de capacité du premier module d'antenne (31) se situe dans la première plage définie ; et
déterminer que le deuxième résultat de détection indique qu'aucun objet n'est présent à une distance du premier module d'antenne (31) du circuit de détection qui est inférieure ou égale au premier seuil défini dans le cas où le premier résultat de détection indique que la valeur de capacité du premier module d'antenne (31) ne se situe pas dans la première plage définie.

14. Terminal mobile, **caractérisé en ce qu'**il comprend :
un processeur (2) ; et
une mémoire (3), configurée pour stocker un programme d'ordinateur apte à s'exécuter sur le processeur (2),
dans lequel le processeur (2) est configuré pour mettre en œuvre des opérations du procédé de détection selon l'une quelconque des revendications 6 à 9 en réponse à l'exécution du programme d'ordinateur.

15. Support de stockage lisible par ordinateur stockant un programme d'ordinateur, **caractérisé en ce que** des opérations du procédé de détection selon l'une quelconque des revendications 6 à 9 sont mises en œuvre en réponse à l'exécution du programme d'ordinateur par un processeur (2).
